# EUROPEAN PATENT SPECIFICATION

(11) **EP 0 575 448 B1**
(45) Date of publication and mention of the grant of the patent: **12.06.1996**
(21) Application number: 92907042.3
(22) Date of filing: 11.03.1992
(51) Int. Cl.: H01M 10/48

(54) **SYSTEM FOR COLLECTING MEASUREMENT DATA IN BATTERY ROOMS**
SYSTEM ZUM SAMMELN VON MESSDATEN IN BATTERIERÄUMEN
SYSTEME DE SAISIE DE DONNEES DE MESURE DANS DES SALLES DE BATTERIES

(30) Priority: 12.03.1991 NO 910984
(43) Date of publication of application: 29.12.1993
(73) Proprietor: VARTA BATTERI AB, S-10246 Stockholm (SE)
(72) Inventor: GOTAAS, Einar, N-0751 Oslo 7 (NO)
(74) Representative: Rackham, Stephen Neil
(86) International application number: NO9200045
(87) International publication number: WO9216979

(56) References cited:
- WO-A-90/15450
- DE-A- 3 702 591
- DE-A- 4 014 737
- US-A- 4 329 406

## Description

The present invention relates to a method and a means for collecting measurement values from a number of sensors monitoring physical parameters in respective ones of a series of accumulator cells. This may for example concern lead accumulators in a submarine, or emergency power batteries in power stations, hospitals or similar.

It is common to all these uses that the accumulator cells are located as a collection in a battery of cells in a room which is classified as explosion dangerous. It is a known fact that lead accumulators liberate oxyhydrogen gas during charging.

In explosion dangerous areas, strict regulations are enforced regarding safety and reliability of the electronic equipment to be placed there. In this connection there are several limiting parameters, like for instance the total energy which can be conducted into the explosion dangerous area. There are also a rather long series of general certifying provisions, with corresponding definitions and requirements.

In a battery room containing for example fifty accumulators in series, it is not difficult in theory to measure four physical parameters per cell and lead the signals out to a common data collection unit. However, this will require perhaps four times fifty conductor pairs, which will often be a very complex and space-demanding arrangement.

In a submarine there may be a total of five hundred lead accumulator cells, and all of these may be connected in series. This means that there may be a DC voltage potential of almost 1400 volts between the lowest and the highest cell in the series connection. In a traditional sensor coupling, such a potential difference will create very large safety problems.

The idea of the present invention is to solve in a practical manner the problems arising in connection with both complex cable multitudes and the use of sufficiently low current to achieve a certificate in explosion dangerous areas class 1 or 0, and at the same time the problem in connection with high DC voltage potentials is solved. A means in accordance with the present invention also complies with all necessary requirements for approval in the explosion dangerous surroundings mentioned above.

The objects just mentioned, are achieved by putting into use a method and a means of the kind appearing from the enclosed patent claims.

A more detailed description of the invention will now be given, with reference to embodiment examples and the enclosed drawings, where
fig. 1 shows a measurement processor,
fig. 2 shows schematically a circuit connection containing several, possibly a few hundred measurement processors, and
fig. 3 shows optoisolators in one single measurement processor.

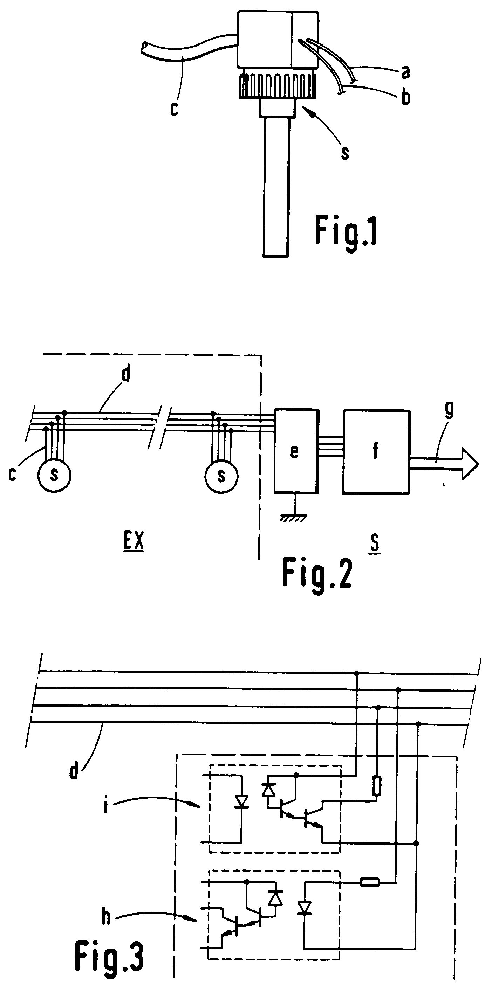

In fig. 1 there is shown a complete measurement processor s. This processor is designed as a unit, which in its lower, elongated end part accomodates a number of sensors for measuring different physical parameters for an accumulator cell. In the top housing a microprocessor is located, which microprocessor reads measurement values from the respective sensors, provides current feed to the same sensors, and also delivers the measurement values, possibly in a somewhat processed form, via the connection cable c to a data bus d (see fig. 2). The microprocessor is also adapted to receive requests via the same data bus.

Reference numerals a and b indicate respectively positive and negative voltage feed wire connected to the poles of the accumulator cell where measurements shall be conducted by the measurement processor. Besides, also the cell voltage is measured by means of these two wires a, b.

Other physical parameters to be measured are, typically, electrolyte density, electrolyte level and electrolyte temperature.

Reference numeral c designates a two-pair cable connected to a common four-conductor data bus d.

In fig. 2 the data bus d, measurement processors s and connection cables c from the measurement processors to the data bus are also present. These elements are located in the explosion dangerous area designated EX, and the data bus d leads out into a safe area S outside, where a so-called "zener
barrier" e is placed in front of a collecting computer f which receives measurement data from the data bus d. This collecting computer f communicates with a control room via a data line g.

A detail of the measurement processor microprocessor is shown in fig. 3, i.e. the detail consists of two optoisolators h and i, respectively an optoisolator for addressing the measurement processor s from the collecting computer f, and an optoisolator via which the measurement processor s retransmits signals.

As previously mentioned, the measurement processor s may contain several sensors for measuring cell voltage, temperature, electrolyte level and electrolyte density for example. In addition, the measurement processor contains a microprocessor which collects and scales the measurement values from the different sensors. The microprocessor will also control the voltage feed to the different sensors, so that the voltage is disconnected in those periods where no measurements are conducted. The total power comsumption can then be reduced to a minimum when the sensors are "asleep". Only that part of the microprocessor which reads and recognizes its own address, possibly a common request, needs any power in this period.

Each measurement processor has its own number, stored in e.g. an EEPROM in the microprocessor, and they can be addressed either one by one, or in larger groups.

The measurement processor is preferably mounted solidly in the accumulator cell, and the feed voltage for the measurement processor is taken from the accumulator cell poles. This means that preferably the measurement processor can be manufactured as part of the lead accumulator cell, and consequently it must be zone classified as a part thereof.

Also regarding e.g. military certification procedures it will be favourable to define the measurement processor as part of the accumulator cell, or the measurement processor system as part of the accumulator cell battery.

Lead accumulators are often built with two cells in a block. It is possible to provide a voltage from a series connection of two cells on the voltage feed wires. This may be favourable in certain cases, when it is desirable that the measurement processor shall function even when the cell voltage is substantially lower than the ordinarily acceptable minimum.

When each measurement processor has its feed voltage from the cell in which a level is to be measured (or possibly a cell in series with a neigbouring cell), the following is achieved: The sensor which reads electrolyte level can be of a capacitive type, using the electrolyte as one condenser side of the sensor. Thereby is eliminated the possible influence on the measurement from the varying electrical characteristics of the liquid, cp. British patent no. 1.318.512.

The connection cable c is connected to respectively transmitter and receiver in two different optoisolators included in the microprocessor of the measuring processor. These optoisolators secure the necessary galvanic separation between the data line and the remaining part of the measurement processor. (The measurement processor may be situated at a potential of more than 1000 volts, while the data line has earth potential via the data collecting unit f.)

The multiplexing of the measurement processors can be implemented in many well known manners, and this constitutes no part of the present invention.

## Claims

1. A method for simultaneously monitoring the electrolyte liquid level in a number of accumulator cells which are possibly grouped in accumulator blocks containing at least two cells per block, where
a microprocessor incorporated in a special measurement processor arranged in correspondence with each accumulator cell, reads measurement values from a sensor which is also incorporated in the same measurement processor and adapted to measure the electrolyte liquid level in the cell,
each measurement processor delivering the acquired measurement information via a connection cable to a common data bus which is connected to a collecting computer,
**characterized** in that the electrolyte liquid level sensor, which is of the capacitive type, utilizes the electrolyte liquid itself as one capacitor side, and that the necessary power feed for the microprocessor and sensor in the measurement processor is taken from the poles of the same accumulator cell or from the poles of the accumulator block comprising said cell, thereby providing a galvanic connection to only one fixed potential for said sensor.

2. A method as claimed in claim 1,
**characterized** i n that the microprocessor in each measurement processor by itself reduces the power consumption of the measurement processor by disconnecting all unnecessary microprocessor parts as well as the sensor in those periods where measurements are not conducted.

3. A means for simultaneously monitoring the electrolyte liquid level in a number of accumulator cells which are possibly grouped in accumulator blocks containing at least two cells per block,
each accumulator cell having a corresponding special measurement processor (s) which comprises a sensor adapted for measuring the electrolyte liquid level in the cell and a and a microprocessor adapted to read and possibly process measurement values from the sensor,
each measurement processor (s) being connected via a connection cable (c) to a common data bus (d) which is also connected to a collecting computer (f),
**characterized** in that the electrolyte liquid constitutes one capacitor side of said sensor, which is of the capacitive type, and that each measurement processor (s) is connected to the poles of its corresponding accumulator cell or of the accumulator block comprising said cell, for feeding current to the microprocessor and the sensor of said measurement processor (s).

4. A means as claimed in claim 3,
**characterized in** that each measurement processor (s) constitutes an integral unit adapted to be fixed or screwed in place in an accumulator cell.

5. A means as claimed in claim 3,
**characterized in** that each measurement processor (s) is incorporated as an integrated part of an accumulator cell.

6. A means as claimed in any one of claims 3-5,
**characterized in** that each measurement processor (s) comprises further sensors for measuring the accumulator liquid temperature and density as well as the pole voltage of the accumulator cell.

7. A means as claimed in any one of claims 3-6,
**characterized in** that the microprocessor in each measurement processor (s) is adapted to reduce the power consumption of the measurement processor (s) by disconnecting all unnecessary microprocessor parts as well as the level sensor and possible further sensors in those periods where measurements are not conducted.

8. The use of a means as claimed in any one of claims 3-7, as a monitoring means for an accumulator battery in a submarine.

9. The use of a means as claimed in any one of claims 3-7, as a monitoring means for an emergency power unit which comprises a number of accumulator cells.

## Patentansprüche

1. Verfahren zum gleichzeitigen Aufzeichnen des Elektrolyt-Flüssigkeitsstandes in einer Anzahl von Akkumulatorzellen, welche in Akkumulatorblöcken gruppiert sein können, die wenigstens zwei Zellen pro Block enthalten, wobei
ein Mikroprozessor, welcher in einem speziellen Meßprozessor untergebracht ist, der zugehörig zu jeder Akkumulatorzelle angeordnet ist, die Meßdaten von einem Sensor liest, welcher auch in dem gleichen Meßprozessor untergebracht ist und geeignet ist, den Elektrolyt-Flüssigkeitsstand in der Zelle zu messen, und wobei
jeder Meßprozessor die gewonnene Meßinformation über ein Verbindungskabel an einen gemeinsamen Datenbus übermittelt, welcher mit einem auswertenden Computer verbunden ist,
**dadurch gekennzeichnet,** daß der Elektrolyt-Flüssigkeitsstandsensor, welcher vom kapazitiven Typ ist, die Elektrolyt-Flüssigkeit selbst als eine Kondensatorplatte einsetzt und daß die notwendige Energie für den Mikroprozessor und den Sensor in dem Meßprozessor von den Polen der gleichen Akkumulatorzelle oder von den Polen des Akkumulatorblocks, welcher die Zellen umfasst abgenommen wird, wodurch eine galvanische Verbindung zu nur einem festen Potential für den Sensor bereitgestellt wird.

2. Verfahren nach Anspruch 1, **dadurch gekennzeichnet,** daß der Mikroprozessor in jedem Meßprozessor selbst den Energieverbrauch des Meßprozessors reduziert, indem alle unbenötigten Mikroprozessorbereiche wie auch der Sensor in den Zeiträumen, in welchen die Messungen nicht durchgeführt werden, abgeschaltet werden.

3. Einrichtung um gleichzeitig den Elektrolyt-Flüssigkeitsstand in einer Anzahl von Akkumulatorzellen aufzuzeichnen, welche in Akkumulatorblöcken, welche wenigstens zwei Zellen pro Block enthalten, angeordnet sein können, wobei
jede Akkumulatorzelle einen zugehörigen speziellen Meßprozessor (s) aufweist, umfassend einen Sensor, der zum Messen des Elektrolyte-Flüssigkeitsstandes in der Zelle geeignet ist, und einen Mikroprozessor, welcher geeignet ist, die Meßdaten des Sensors zu lesen und möglicherweise zu verarbeiten,
jeder Meßprozessor (s) über ein Verbindungskabel (c) mit einem gemeinsamen Datenbus (d) verbunden ist, welcher auch mit einem auswertenden Computer (f) verbunden ist,
**dadurch gekennzeichnet,** daß die Elektrolyt-Flüssigkeit eine Kondensatorplatte des Sensors bildet, welcher vom kapazitiven Typ ist und daß jeder Meßprozessor mit den Polen der entsprechenden Akkumulatorzelle oder des Akkumulatorblocks, welcher die Zelle umfasst, verbunden ist, um dem Mikroprozessor und dem Sensor des Meßprozessors (s) Strom zuzuführen.

4. Vorrichtung nach Anspruch 3, **dadurch gekennzeichnet,** daß jeder Meßprozessor (s) eine integrale Einheit bildet, welche geeignet ist, an einer Stelle in einer Akkumulatorzelle befestigt oder angeschraubt zu werden.

5. Vorrichtung nach Anspruch 3, **dadurch gekennzeichnet,** daß jeder Meßprozessor (s) als ein integrierter Teil einer Akkumulatorzelle eingefügt wird.

6. Vorrichtung nach einem der Ansprüche 3-5, **dadurch gekennzeichnet,** daß jeder Meßprozessor (s) des weiteren Sensoren zum Messen der Temperatur und der Dichte der Akkumulatorflüssigkeit, wie auch der Polspannung der Akkumulatorzelle umfaßt.

7. Vorrichtung nach einem der Ansprüche 3-6, **dadurch gekennzeichnet,** daß der Mikroprozessor geeignet ist, den Stromverbrauch des Meßprozessors (s) zu reduzieren, indem alle unbenötigen Mikroprozessorbereiche wie auch der Flüssigkeitsstandsensor und möglicherweise weitere Sensoren in den Zeiträumen, in denen die Messungen nicht durchgeführt werden, abgeschaltet sind.

8. Verwendung einer Einrichtung nach einem der Ansprüche 3-7 als eine Aufzeichnungseinrichtung für einen Akkumulator für ein U-Boot.

9. Verwendung einer Einrichtung nach einem der Ansprüche 3-7 als eine Aufzeichnungseinrichtung für eine Notstromeinheit, welche eine Anzahl von Akkumulatorzelle umfaßt.

## Revendications

1. Procédé permettant de contrôler simultanément le niveau de l'électrolyte liquide dans un certain nombre d'éléments d'accumulateurs qui peuvent être regroupés en blocs d'accumulateurs contenant au moins deux éléments par bloc, où :
un microprocesseur incorporé dans un processeur de mesure spécial, disposé en correspondance avec chaque élément d'accumulateur, lit des valeurs de mesure venant d'un capteur, qui est lui aussi incorporé dans ce même processeur de mesure et est destiné à mesurer le niveau de l'électrolyte liquide dans l'élément,
chaque processeur de mesure délivrant via un câble de connexion les informations de mesure acquises à un bus de données commun qui est raccordé à un ordinateur de saisie,
caractérisé en ce que le capteur mesurant le niveau de l'électrolyte liquide, qui est un capteur du type capacitif, utilise l'électrolyte liquide lui-même au titre d'un côté de condensateur, et en ce que l'alimentation en énergie nécessaire du microprocesseur et du capteur se trouvant dans le processeur de mesure est prélevée sur les pôles de ce même élément d'accumulateur ou sur les pôles du bloc d'accumulateurs comprenant ledit élément, de sorte qu'il n'est prévu de connexion galvanique, pour ledit capteur, qu'à un seul potentiel fixe.

2. Procédé selon la revendication 1, caractérisé en ce que le microprocesseur se trouvant dans chaque processeur de mesure réduit de lui-même la consommation électrique du processeur de mesure en déconnectant toutes les parties inutiles du microprocesseur ainsi que le capteur dans les moments où aucune mesure n'est effectuée.

3. Moyen permettant de contrôler simultanément le niveau de l'électrolyte liquide dans un certain nombre d'éléments d'accumulateurs qui peuvent être regroupés en blocs d'accumulateurs contenant au moins deux éléments par bloc,
chaque élément d'accumulateur ayant un processeur de mesure spécial correspondant (s) qui comprend un capteur destiné à mesurer le niveau de l'électrolyte liquide dans l'élément et un microprocesseur destiné à lire et, éventuellement, traiter des valeurs de mesure fournies par le capteur,
chaque processeur de mesure (s) étant connecté via un câble de connexion (c) à un bus de données commun (d) qui est également connecté à un ordinatcur de saisie (f),
caractérisé en ce que l'électrolyte liquide constitue un côté de condensateur dudit capteur, lequel est du type capacitif, et en ce que chaque processeur de mesure (s) est connecté aux pôles de son élément d'accumulateur correspondant ou de son bloc d'accumulateurs comprenant ledit élément, pour l'alimentation en courant électrique du microprocesseur et du capteur dudit processeur de mesure (s).

4. Moyen selon la revendication 3, caractérisé en ce que chaque processeur de mesure (s) constitue une unité intégrale qui est destinée à être fixée ou vissée en position dans un élément d'accumulateur.

5. Moyen selon la revendication 3, caractérisé en ce que chaque processeur de mesure (s) est incorporé au titre d'une partie intégrée d'un élément d'accumulateur.

6. Moyen selon l'une quelconque des revendications 3 à 5, caractérisé en ce que chaque processeur de mesure (s) comprend d'autres capteurs servant à mesurer la température et la densité du liquide de l'accumulateur ainsi que la tension aux pôles de l'élément d'accumulateur.

7. Moyen selon l'une quelconque des revendications 3 à 6, caractérisé en ce que le microprocesseur contenu dans chaque processeur de mesure (s) est conçu pour réduire la consommation électrique du processeur de mesure (s) par le fait qu'il déconnecte toutes les parties inutiles du microprocesseur ainsi que le capteur de niveau et d'autres éventuels capteurs dans les moments où aucune mesure n'est effectuée.

8. Utilisation d'un moyen selon l'une quelconque des revendications 3 à 7, comme moyen de contrôle d'une batterie d'accumulateurs dans un sous-marin.

9. Utilisation d'un moyen selon l'une quelconque des revendications 3 à 7, comme moyen de contrôle d'une unité d'alimentation électrique de secours qui comprend un certain nombre d'éléments d'accumulateurs.
